# EUROPEAN PATENT APPLICATION

(11) **EP 4 718 990 A1**
(43) Date of publication of application: **01.04.2026**
(21) Application number: 24202855.3
(22) Date of filing: 26.09.2024
(51) Int. Cl.: H10D 84/01, H10D 30/66, H10D 84/83

(54) **SEMICONDUCTOR DIE WITH A VERTICAL TRANSISTOR DEVICE**

(71) Applicant: Infineon Technologies Austria AG, 9500 Villach (AT)
(72) Inventor: VYTLA, Rajeev Krishna, 9500 Villach (AT); JABS, Dominic, 9500 Villach (AT); ROESCH, Maximilian, 9524 St. Magdalen (AT)
(74) Representative: Szynka Smorodin Patentanwälte Partnerschaft mbB

(57) **Abstract**

The invention relates to a semiconductor die (1) with a semiconductor body (10), the semiconductor die (1) comprising: a vertical transistor device (20); an additional transistor device (40) comprising a channel region (43.1) configured for a vertical current flow; an isolation trench (60) extending into the semiconductor body (10); an isolation well (70) made of a second doping type; the isolation well (70) being arranged vertically below the additional transistor device (40), the isolation trench (60) being arranged laterally between the additional transistor device (40) and the vertical transistor device (20), wherein the isolation trench (60) extends to a depth (65) which lies vertically between an upper end (70.1) of the isolation well (70) and the second side (10.2) of the semiconductor body (10).

## Description

### TECHNICAL FIELD

The present disclosure relates to a semiconductor die with a semiconductor body, comprising a vertical transistor device.

### BACKGROUND

A vertical transistor device may have a first vertical load region at a first side of the semiconductor body and a second vertical load region at a vertically opposite second side of the semiconductor body, e.g. a source region at the first side and a drain region at the second side. The first and second vertical load region may be made of a first doping type, e.g. in combination with a body region arranged vertically between and made of a second doping type.

### SUMMARY

Examples of the present application are directed at an advantageous semiconductor die with a semiconductor body.

In an embodiment, the semiconductor die comprises an additional transistor device in addition to the vertical transistor device, wherein an isolation trench is arranged laterally in between the devices. Further, an isolation well made of a second doping type is formed in the semiconductor body. It is arranged below the additional transistor device, e.g. vertically between the additional transistor device and the second side of the semiconductor body, wherein the second side may be made of the first doping type. By way of example, a first doping type region, e.g. the semiconductor substrate, may form the second side, wherein the isolation well is arranged above this first doping type region. Referring for instance to the vertical position of an upper end of the isolation well, the isolation trench may extend to a depth vertically between this upper end and the second side of the semiconductor body.

In other words, the isolation trench may extend at least into the isolation well but not completely through the semiconductor body, e.g. not all the way down to the second side of the semiconductor body. A lower end of the isolation trench can for instance be arranged below an upper end of the isolation well and above the second side of the semiconductor body, e.g. at a vertical distance below the upper end of the isolation well and at a vertical distance above the second side of the semiconductor body. The isolation trench ending above the second side of the semiconductor body, e.g. not intersecting the semiconductor body completely (for example not extending through a substrate of the semiconductor body), can for instance reduce an effort in manufacturing. By way of example, a thinning of the wafer, e.g. backside grinding, can be less critical, e.g. also with respect to a wafer handling in subsequent steps.

The isolation trench may provide for a lateral isolation and the isolation a well made of the second doping type can form a vertical isolation, for instance via a junction between the isolation well and the second side of the semiconductor body, e.g. the substrate or common drain backside. In other words, the isolation well below the additional device may form an electrical isolation from the semiconductor substrate. In combination, the vertical and lateral isolation can for instance reduce parasitic influences between the devices.

Further embodiments and features are provided in the claims and throughout this disclosure. Therein, the individual features shall be disclosed independently of a specific claim category, the disclosure relates to apparatus and device aspects but also to method and use aspects. If for instance a die manufactured in a specific way is described, this is also a disclosure of a respective manufacturing process, and vice versa. In general words, an approach of this application is to provide an integrated device with a combined vertical and lateral isolation in the semiconductor body.

In an embodiment, the vertical transistor device comprises a first vertical load region arranged at a first side of the semiconductor body and a second vertical load region arranged at a second side of the semiconductor body opposite to the first side. The first vertical load region and the second vertical load region may be made of a first doping type opposite to the second doping type, i.e. opposite to the doping type of the doping well.

The first vertical load region can be a source region and the second vertical load region a drain region, wherein this drain region is arranged at the second side ("backside") of the semiconductor body. Therein, the implant region or layer, e.g. substrate, forming the drain region may extend laterally also in the area of the additional transistor device, the well region forming a junction isolation towards this first doping type region below. The additional transistor device may be embedded laterally by the isolation trench, which as seen in a vertical top view can form a closed line around the additional transistor device (see in detail below), and be embedded vertically by the isolation well. The additional transistor device can for instance be connected as a pulldown device to the vertical transistor device, e.g. vertical FET, for instance connect the gate terminal of the vertical FET to ground, see in detail below.

By way of example, each of the vertical and the additional transistor device comprises at least one transistor device cell, wherein the transistor device cells of the vertical and of the additional transistor device have for instance the same source doping and/or the same body doping and/or the same drift region doping and/or the same trench depth and/or the same gate oxide thickness. This may allow for a reuse of processing step, e.g. reduce an integration effort for the additional transistor device. By way of example, the device cells of the vertical and the additional transistor device may be identical in construction (e.g., they may only vary with respect to each other due to minor manufacturing variations).

A lower end of the body region of the additional transistor device may lie on the same vertical height as a lower end of the body region of the vertical transistor device. Alternatively or in addition, a lower end of the source region of the additional transistor device may lie on the same vertical height as a lower end of the source region of the vertical transistor device. Alternatively or in addition, an upper end of the drift region of the additional transistor device may lie on the same vertical height as an upper end of the drift region of the vertical transistor device. Alternatively or in addition, a lower end of the drift region of the additional transistor device may lie on the same vertical height as a lower end of the drift region of the vertical transistor device. Alternatively or in addition, an upper end of the drain region of the additional transistor device may lie below a lower end of the gate trench of the additional and/or vertical transistor device, e.g. lie on the same vertical height as an upper end of the drain region of the vertical device.

The semiconductor body may comprise a semiconductor substrate, e.g. made of the first doping type. In other words, the vertical transistor device and the additional transistor device may share the same semiconductor substrate, the semiconductor substrate extending for instance in the areas of the vertical transistor device and of the additional transistor device without a lateral interruption in between. On the semiconductor substrate, one or more epitaxial semiconductor layers may be arranged, e.g. on a first side (frontside) of the semiconductor substrate. That surface of an uppermost epitaxial layer, which faces away from the substrate, can form the first side of the semiconductor body. The second side can for instance be that side of the substrate which faces away from the epitaxial layer or layers. Independently of an epitaxial layer or layer stack, the first side and the second side are those sides of the semiconductor body which lie vertically opposite to each other, i.e. face away from each other with respect to the vertical direction.

The vertical direction, to which "vertical" or "vertically" refer, lies for instance perpendicular to a surface of the die, e.g. the surface of a substrate or an epitaxial layer formed on the substrate. "Above" means closer to the first side of the semiconductor body and "below" means closer to the second side of the semiconductor body. An "upper end" of an element or region in the semiconductor body is that end which lies closer to or in the first side of the semiconductor body, whereas a "lower end " is that end which lies closer to or in the second side. The isolation trench may for instance extend from the first side into the semiconductor body and have its lower end above the second side of the semiconductor body. "Lateral" or "laterally" referred to the lateral directions perpendicular to the vertical direction, in which for instance the die area is taken.

The first vertical load region, e.g. source region, and the second vertical load region, e.g. drain region, of the vertical device are disposed at the vertically opposite sides of the semiconductor body, wherein the "first side" can also be referred to as a frontside and the "second side" as a backside. In a body region of the device, a channel can be formed by applying a voltage to the gate electrode of the vertical device. Even though the transistor device as a whole is considered "vertical" due to its vertically opposite source and drain region, a lateral channel is conceivable in general, e. g. in case of a gate region disposed on top of the body region (and a source region laterally aside the latter).

In an embodiment, however, the gate electrode of the vertical device is arranged in a gate trench laterally aside the body region and the channel extends vertically aside the trench. Below the body region, a drift region may be arranged, e.g. made of the first doping type like the drain region but with a lower doping concentration (e.g. compared to the substrate). Independently of the specific device design, the first doping type may be n-type and the second doping type may be p-type.

In an embodiment, the isolation trench extends through the isolation well, e.g. intersects the isolation well vertically (but ends above the second side of the semiconductor body). The lower end of the isolation trench may be arranged on the same vertical height as the lower end of the isolation well or may be arranged below, i.e. offset downwards from the lower end of the isolation well. This allows parasitic effects, for example, to be reduced or avoided, e.g. parasitics of a pn diode. With an adapted trench process, the isolation trench may be etched, for example, so that its lower end is on the same vertical height as the lower end of the isolation well.

As discussed above, the vertical transistor device may comprise a gate trench, the gate electrode of the vertical device being arranged in the gate trench and laterally aside the body region. Alternatively or in addition, the additional transistor device may comprise a gate trench, the gate electrode of the additional device being arranged in the gate trench and laterally aside the body region. In an embodiment, the isolation trench extends deeper than the gate trench of the vertical device and/or than the gate trench of the additional device, the lower end of the isolation trench arranged below a lower end of the respective gate trench. In addition to the gate electrode, the respective gate trench may comprise a field electrode below the gate electrode. In some embodiments the gate trenches of the vertical transistor device and the gate trenches of the additional transistor device run in parallel in a same direction. In addition to that or as an alternative, the gate trenches of the vertical transistor device and the gate trenches of the additional transistor device may have at least one of substantially a same depth and substantially a same width. For example, the gate trenches of the vertical transistor device and the gate trenches of the additional transistor device may be fabricated at a same processing step.

In an embodiment, the isolation trench, as seen in a vertical top view, forms a closed line around the additional device. Therein, in the area enclosed by the isolation trench, the isolation well may extend uninterrupted, e.g. form a continuous layer inside the area defined by the isolation trench. As seen in a horizontal cross-section through the isolation well, the sectional plane perpendicular to the vertical direction, the isolation well may form a continuous area (without holes) which fills the area defined by the isolation trench entirely. This can for instance apply on any vertical height, e.g. for any horizontal cross-section through the isolation well.

In an embodiment, the isolation well is formed in an epitaxial layer which is arranged on the semiconductor substrate. In general, an additional epitaxial layer may be arranged in between, in an embodiment, however, the epitaxial layer with the well region is arranged directly on the semiconductor substrate. Independently of these details, a buried first doping type region may be formed in the same epitaxial layer in an area of the vertical device. In other words, in the same epitaxial layer or stack of sublayers, the isolation well may be formed in the area of the additional device and the buried first doping type region may be formed in the area of the vertical device. An upper end of the isolation well may be arranged basically on the same vertical height as an upper end of the buried first doping type region and/or a lower end of the isolation well may be arranged basically on the same vertical height as a lower end of the buried first doping type region, e.g. in the first side/upper side of the semiconductor substrate.

The buried first doping type region, which is made of the first doping type, may form a portion of the drain region of the vertical device. Consequently, the drain region of the vertical device can, for example, be enlarged or be brought closer to the channel, which can for instance reduce an on-resistance. The buried first doping type region can for instance have a higher doping concentration than the drift region of the vertical device. The buried first doping type region, which forms a vertical portion of the drain region of the vertical device, is arranged on the same height as the isolation well, the buried first doping type region and the isolation well isolated from each other by the isolation trench in between.

The at least one epitaxial layer, in which the isolation well and/or the buried first doping type region are formed, can for instance have a thickness of at least 3 µm, 4 µm or 5 µm, possible upper limits being for example at most 15 µm, 10 µm or 8 µm.

The additional device may comprise a first and a second additional load region, the first additional load region being for instance a source region and the second additional load region being for instance a drain region of the additional device. The first additional load region may be arranged at the first side of the semiconductor body, whereas the second additional load region is, in an embodiment, embedded into the semiconductor body. In other words, the second additional load region, e.g. drain region, is arranged vertically between the first side of the semiconductor body and the isolation well, an upper end of the second additional load region being offset downwards from the first side of the semiconductor body. Therein, the second additional load region may be arranged directly on the isolation well, i.e. lie adjacent to the isolation well, or another layer (e.g. "intermediate region") may be arranged in between.

In case of an additional transistor device with a source region and a drain region, a body region of the additional device may be arranged vertically between. In addition, the additional device may comprise a drift region arranged vertically between the body region and the drain region and having a lower doping concentration compared to the drain region. In a gate trench discussed above, a gate electrode may be arranged laterally aside and capacitively coupling to the body region, optionally a field electrode capacitively coupling to the drift region may be arranged below.

In an embodiment, the second additional load region, e.g. drain region, is electrically connected via a contact element which extends from the first side into the semiconductor body. The contact element may comprise a sinker implant and/or a metal plug, e.g. the sinker implant forming a lower portion and the metal plug forming an upper portion of the contact element. Via the contact element, a current routed vertically through the additional device and collected in the second additional load region, e.g. drain region, may be routed to the first side of the semiconductor body.

In other words, the additional device may be configured for a vertical current flow, e.g. vertically through the channel formed in the body region aside the gate trench, wherein a drain contact is provided at the first side (via the contact element to the drain region). Though having a source contact and a drain contact at the first side of the semiconductor body, the current flow through the additional device is vertical, which can for instance allow for the same device cells be used as for the vertical device. Therein, the reference to a "vertical" current flow shall, for example, not exclude a lateral current spreading, e.g. in the drift region (as also known from vertical devices). Further, the current collected in the drain region of the additional transistor device may also have a lateral component there, e.g. towards the contact element.

In an embodiment, the second additional load region, e.g. drain region, of the additional device is connected via the contact element to a terminal of the vertical device, for instance via a metallization and/or polysilicon structure. The second load region may be connected to the gate terminal of the vertical device, the additional device serving for instance as an integrated pulldown device which in a conducting state can connect the gate terminal of the vertical device to ground (e.g. to the source domain in case of a low side switch).

In an embodiment, a surrounding trench is arranged laterally between the additional device and the contact element. The surrounding trench can for instance provide for a field reduction or shielding between a different potential at the first additional load region and the vertical contact element, which is on the same potential like the second additional load region. In other words, the surrounding trench may be arranged between the source region and the drain contact of the additional device. As seen in a vertical top view, the surrounding trench may enclose the additional device entirely, e.g. form a closed ring inside a closed ring formed by the isolation trench.

In comparison to the isolation trench, the surrounding trench may extend to a smaller depth, a lower end of the surrounding trench being arranged on a larger height than the lower end of the isolation trench. The lower end of the surrounding trench may be arranged above the second additional load region of the additional device, the surrounding trench extending for instance into and ending in the drift region.

As mentioned above, an intermediate region can be arranged vertically between the second additional load region and the isolation well. In other words, the intermediate region may be embedded vertically between the second additional load region and the isolation well, e.g. lie adjacent to the second additional load region and/or adjacent to the isolation well. Independently of these details, the intermediate region may be made of the first doping type but with a lower doping concentration than the second additional load region or may be undoped.

In an embodiment, the second additional load region, e.g. drain region, of the additional transistor device is formed in an epitaxial layer, wherein an embedded first doping type region is formed in the same epitaxial layer in the area of the vertical device. By way of example, this epitaxial layer may span over the entire semiconductor body. The embedded first doping type region can for instance be embedded between the drift region above and the buried first doping type region below. It is formed in the area of the vertical device and can for instance have the same doping concentration and/or vertical extension like the second additional load region of the additional device, e.g. be formed simultaneously. As to the vertical device, it may form a portion of the second vertical load region, e.g. drain region, of the vertical device, the drain region being for instance lifted, see the remarks above.

In an embodiment, a method of manufacturing the semiconductor die may comprise forming the isolation trench and forming the isolation well. Forming the isolation trench can comprise etching and filling the trench, for instance with an insulating filler. The insulating filler, e.g. oxide, can fill the insulating trench completely or cover only the sidewalls, e.g. in combination with an inlay which fills up the trench.

In an embodiment, forming the isolation well and forming the buried first doping type region comprises (i) forming an epitaxial layer of a second doping type. This may be done by an in situ doping during the deposition and/or by a deposition of the epitaxial layer combined with a subsequent doping. Independently of these details, in a subsequent step (ii), a first doping type implantation is introduced locally to form at least a portion of the buried first doping type region. Therein, steps i) and ii) may be repeated a plurality of times to form a layer from a plurality of stacked sublayers, each sublayer having the same lateral doping profile.

In an embodiment, a method of manufacturing a semiconductor die comprises:
i) forming an epitaxial layer, e.g. on the semiconductor substrate;
ii) etching trenches into the epitaxial layer in the area of the vertical transistor device and/or in the area of the additional transistor device;
iii) introducing an implantation obliquely into the trenches;
iv) filling the trenches with epitaxial fillers;
v) out diffusing the implantation into the epitaxial fillers.

The oblique implantation via the trenches, which are filled subsequently, can for instance allow for doping a comparably thick epitaxial layer in one step, e.g. as an alternative to the sublayer approach discussed above. The oblique implantation in step iii) may for instance be a first doping type implantation, e.g. to form the buried first doping type region in the area of the vertical device.

In an embodiment, the epitaxial layer is provided with a second doping type implantation before, e.g. prior to etching the trenches in step ii). The second doping type implantation may be introduced in both, the area of the vertical and of the lateral device, for instance by an in situ doping during the deposition of the epitaxial layer. Then, the trenches may be etched only in the area of the vertical device, so that the first doping type implantation is introduced there, e.g. forming the buried first doping type region.

Alternatively, the trenches may be etched in the area of the vertical transistor device and in the area of the additional transistor device, wherein a second doping type implantation is introduced to all trenches. Then, in a subsequent step, the trenches in the area of the additional transistor device may be covered, e.g. by a resist mask, so that a subsequent first doping type implantation is introduced only to those trenches arranged in the area of the vertical device. The mask may then be removed and the trenches can be filled with epitaxial fillers, see above.

### BRIEF DESCRIPTION OF THE DRAWINGS

Below, the semiconductor die and method of manufacturing are explained in further detail by means of exemplary embodiments. Therein, the individual features can also be relevant in a different combination.
- Figure 1a: shows a semiconductor die with a semiconductor body in a vertical cross-section;
- figure 1b: shows a detailed view of a vertical transistor device;
- figure 1c: shows a detailed view of an additional transistor device;
- figure 1d: shows a horizontal cross-section through the semiconductor body of figure 1a;
- figure 2: shows a semiconductor die with a vertical transistor device and an additional transistor device in a vertical cross-section;
- figure 3: shows the semiconductor die in a vertical top view;
- figures 4 a-c: illustrate a possibility for manufacturing a buried doped region;
- figures 5 a-c: illustrate alternative steps for manufacturing a buried doped region;
- figure 6: summarizes some manufacturing steps in a flow diagram.

### DETAILED DESCRIPTION

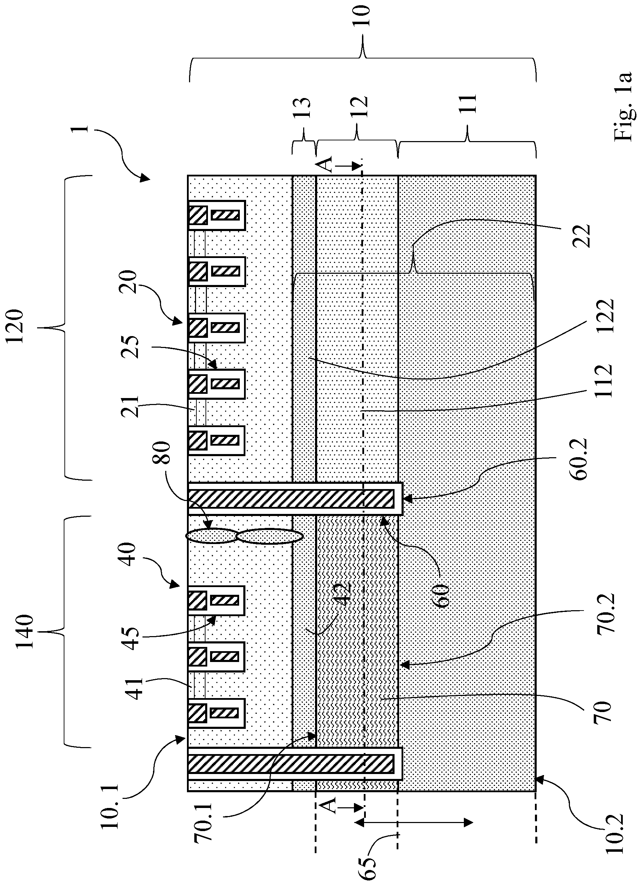

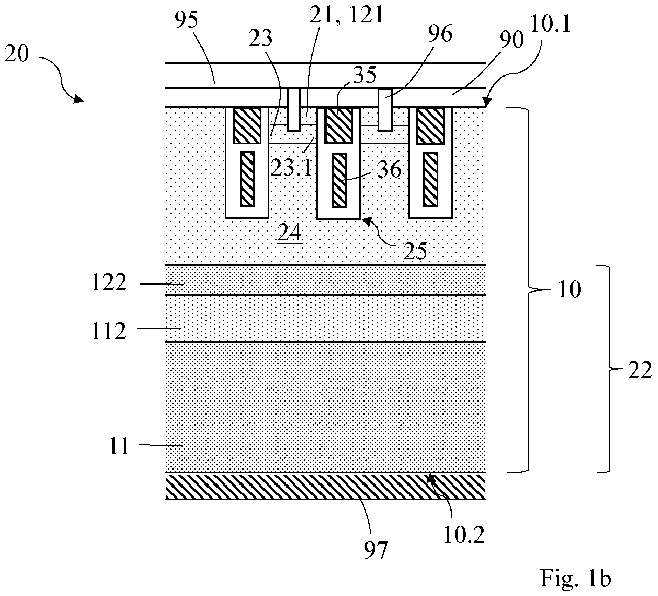

**Figure 1a** shows a semiconductor die 1 with a semiconductor body 10. The semiconductor body 10 comprises a semiconductor substrate 11 and epitaxial layers which are discussed in further detail below. In an area 120 of the semiconductor die 1, a vertical transistor device 20 is formed. It comprises a first vertical load region 21, which is arranged at a first side 10.1 of the semiconductor body 10, and a second vertical load region 22 arranged at a vertically opposite second side 10.2 of the semiconductor body 10, see figure 1b in further detail.

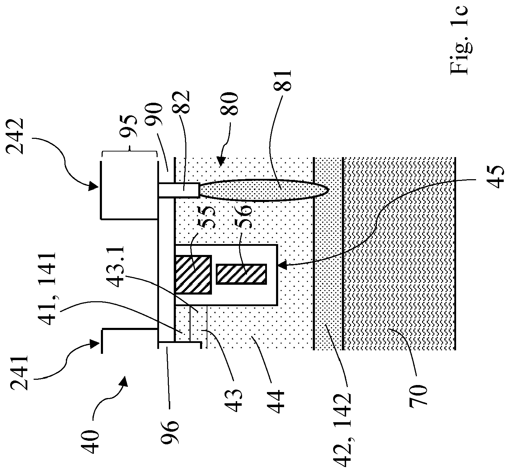

In another area 140 of the semiconductor die 1, an additional transistor device 40 is arranged. It comprises a first additional load region 41, which is arranged at the first side 10.1 of the semiconductor body 10, and a second additional load region 42, which in the example shown is embedded into the semiconductor body 10, see figure 1c in further detail. Below the additional transistor device 40, an isolation well 70 is arranged. It is made of a second doping type, i.e. of an opposite doping type compared to the first an second vertical load region 21, 22 made of a first doping type.

Laterally between the additional transistor device 40 and the vertical transistor device 20, an isolation trench 60 is arranged. It extends from the first side 10.1 into the semiconductor body 10, e.g. extends deeper than the gate trenches 25 of the vertical transistor device 20 and gate trenches 45 of the additional transistor device 40. However, the isolation trench 60 does not intersect the semiconductor body 10 completely, it extends to a vertical depth 65 above the second side 10.2 of the semiconductor body 10. In the example shown, it extends into but not through the semiconductor substrate 11, a lower end 60.2 of the isolation trench 60 is arranged below a lower end 70.2 of the isolation well 70. In figure 1a, the second additional load region 42, which is made of the first doping type, is arranged directly on the isolation well 70, it lies adjacent to an upper end 70.1 of the isolation well 70.

In operation, with the first additional load region 41 at the first side 10.1 and second additional load region 42 embedded vertically into the semiconductor body 10, a vertical current flow through the additional transistor device 40 results. Via a contact element 80, which extends from the first side 10.1 into the semiconductor body 10, the current is routed to the first side 10.1. In other words, though having a vertical current flow in the channel, the contacting of the additional transistor device 40 is realized on the same side of the semiconductor body 10.

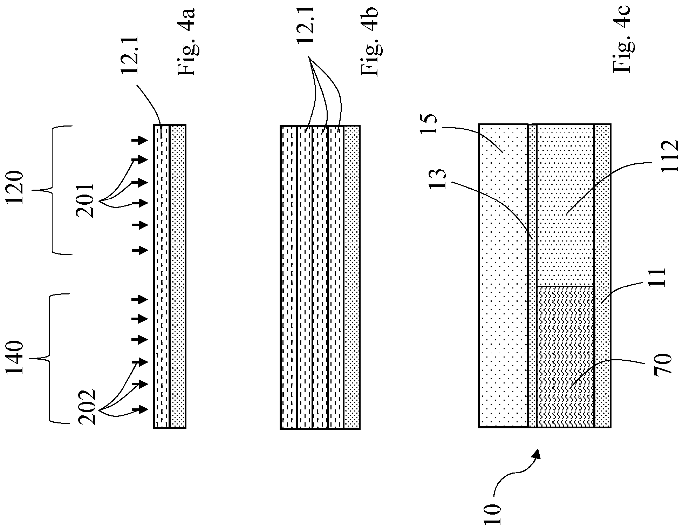

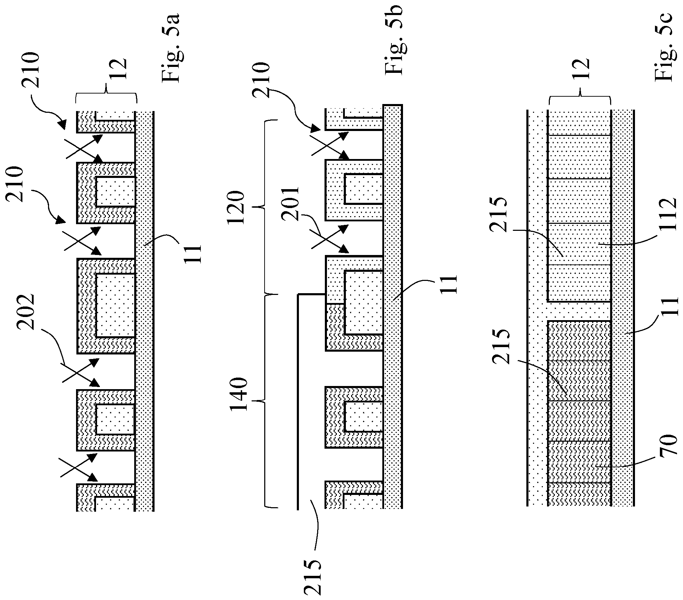

The isolation well 70 is formed in an epitaxial layer 12, i.e. in the area 140 of the additional transistor device 40. In the area 120 of the vertical transistor device 20, a buried first doping type region 112 is formed. As discussed with reference to figures 4 and 5, the epitaxial layer 12 may be deposited as one single layer or be made of a plurality of sublayers.

The second additional load region 42 is formed in an epitaxial layer 13 above. The epitaxial layer 13 may be highly doped, e.g. have a higher doping concentration than the buried first doping type region 112 and/or a drift region above. In the area 120 of the vertical transistor device 20, the at least one epitaxial layer 13 is part of the second vertical load region 22. In other words, the buried first doping type region 112 and the embedded first doping type region 122 lift the second vertical load region 22, i.e. bring it closer towards the first side 10.1 of the semiconductor body 10.

**Figure 1b** illustrates a vertical device 20 in a more detailed cross-sectional view. In the example shown, the first vertical load region 21 is a source region 121 and the second vertical load region is a drain region 122. In addition, the vertical transistor device 20 comprises a body region 23 below the source region 121 and a drift region 24 below the body region 23. In the body region 23, a channel region 23.1 is formed aside the gate trench 25, i.e. aside a gate electrode 35 in the gate trench 25. Below the gate electrode 35, a field electrode 36 is disposed in the gate trench 25. The field electrode 36 capacitively couples to the drift region 24 and the gate electrode 35 capacitively couples to the body region 23, i.e. channel region 23.1.

On the first side 10.1 of the semiconductor body 10, an insulating layer 90 is arranged, a metallization 95 disposed on the insulating layer is shown schematically. Via contact plugs 26, the metallization is electrically connected to the source region 121 and the body region 23. Via a gate voltage applied to the gate electrode 35, which is contacted outside drawing plane, a vertical current flow through the channel region 23.1 can be controlled, i.e. current flow between the source region 121 and the drain region 122. On the second side 10.2 of the semiconductor body 10, a backside metallization 97 may be arranged.

**Figure 1c** illustrates an additional transistor device 40 in a more detailed cross-sectional view. In the example shown, the first additional load region 41 is a source region 141 and second additional load region 42 is a drain region 142. Further, the additional transistor device 40 comprises a body region 43 below the source region 141 and a drift region 44 below the body region 43. In the gate trench 45, a gate electrode 55 and a field electrode 56 are arranged, the gate electrode 55 capacitively coupling to the body region 43 and the field electrode 56 capacitively coupling to the drift region 44.

In the metallization 95, a source contact 241 and a drain contact 242 are formed. The source contact 241 is connected via a contact plug 96 to the source region 141 and the body region 43. By applying a voltage to the gate electrode 55, a vertical current flow in the channel region 43.1 can be controlled, i.e. vertical current flow between the source region 141 and the drain region 142 below. Via the vertical contact 80, the drain contact 242 is connected to the drain region 142. In detail, the contact element 80 comprises a sinker implant 81 and a contact plug 82, which may be manufactured simultaneously with the contact plug 96.

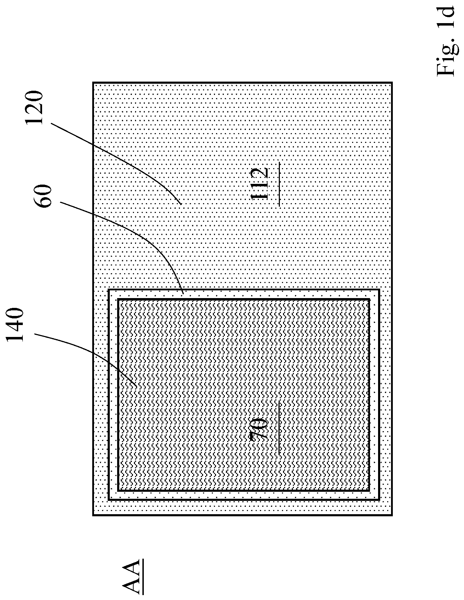

**Figure 1d** shows a horizontal cross-section through the semiconductor body 10, see the sectional plane AA as referenced in figure 1a. The isolation trench 60 extends around the area 140 of the additional transistor device, i.e. forms a closed line. This area 140 laterally defined by the isolation trench 60 is filled completely by the isolation well 70, the isolation well 70 having no opening or the like. In the area 120, the sectional plane goes through the buried first doping type layer 112.

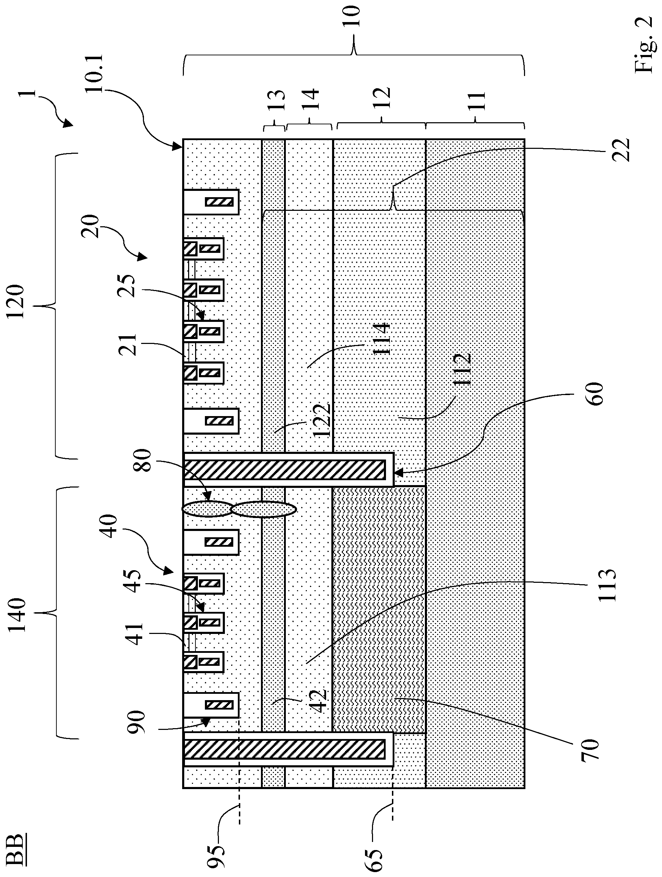

**Figure 2** illustrates a semiconductor die 1 in a cross-sectional view comparable to figure 1a. Generally, in this disclosure, the like reference numerals indicate the like elements or elements having the like function and reference is made to the description of the respectively other figures as well. The following description highlights mainly the differences.

In contrast to figure 1a, the second additional load region 42 of the additional transistor device 40 is not arranged directly on the isolation well 70. Instead, an intermediate region 113 is arranged in between, which may be undoped. Alternatively, the intermediate region 113 can be made of the first doping type but with a lower doping concentration compared to the second additional load region 42. It is formed in an epitaxial layer 14, in which a higher first doping type implantation may be introduced in the area 120 of the vertical transistor device 20, i.e. in the first doping type region 114.

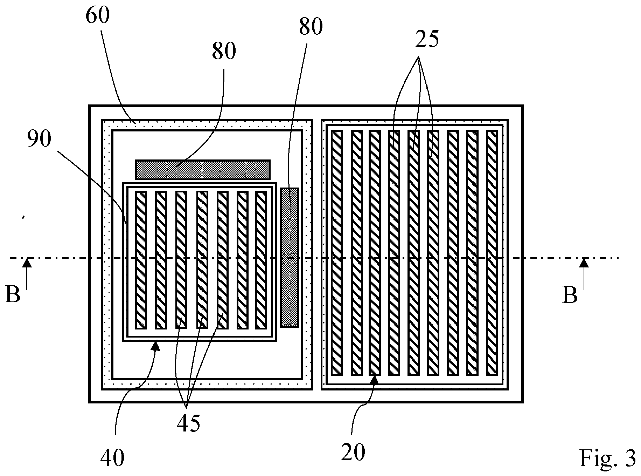

Laterally between the additional transistor device 40 and the contact element 80, a surrounding trench 90 is arranged. It extends to a depth 95 above the second additional load region 42 but deeper than the gate trenches 45 . As apparent from the top view shown in figure 3, the surrounding trench 90 forms a closed line around the additional transistor device 40, i.e. around the gate trenches 45. Further, **figure 3** illustrates the trench isolation 60 forming a closed line around the additional transistor device 40.

As can be further seen in figure 3, the contact element 80 can be arranged on more than one side of the additional transistor device 40. In figure 3, the sectional plane BB of figure 2 is indicated (wherein the number of gate trenches 25, 45 differs between cross-sectional and top view for display reasons).

**Figures 4 a-c** illustrate a first possibility for manufacturing the isolation well 70 made of the second doping type with the buried first doping type region 112 aside. Therein, the epitaxial layer 12 is not deposited as one single layer, instead a plurality of sublayers 12.1 are deposited one of the other. Therein, after the deposition of a respective sublayer 12.1, a first doping type implantation 201 is introduced in the area 120 of the vertical transistor device and a second doping type implantation 202 is introduced in the area of the additional transistor device, see figure 4 a.

In detail, the second doping type implantation 202 can for instance be introduced first to the entire sublayer 12.1, wherein a mask having an opening in the area 120 of the vertical transistor device may be applied thereafter. The subsequent first doping type implantation 201 is then selectively applied to the area 120. Independently of these details, as illustrated in figure 4b, further sublayers 12.1 can be deposited subsequently one after the other, each being selectively doped in the areas 120, 140.

Figure 4c illustrates the semiconductor body 10 after the isolation well 70 and the buried first doping type region 112 have been formed, they are covered by the epitaxial layer 13 and an epitaxial layer 15 in which the drift region and further device elements are formed later on.

**Figures 5a****-c** illustrate an alternative approach for forming the isolation well 70 and the buried first doping type region 112. Therein, the epitaxial layer 12 is initially deposited in one step, in the example shown as an undoped layer. Then, a plurality of trenches 210 are etched into the epitaxial layer 12 and an oblique second doping type implantation 202 is introduced into the trenches 210, see figure 5a.

Then, as illustrated in figure 5b, a mask 215 is formed to cover those trenches 210 which are arranged in the area 150 of the additional transistor device. Consequently, a subsequent oblique first doping type implantation 201 is only applied to the trenches 210 in the area 120 of the vertical transistor device. After a removal of the mask 215, the trenches 210 are respectively filled with an epitaxial filler 215 to form a continuous epitaxial layer 12. Then, the respective doping type implantation, i.e. second doping type implantation in the area 140 and first doping type implantation in the area 120, is outdiffused into the fillers 215 in a temper step.

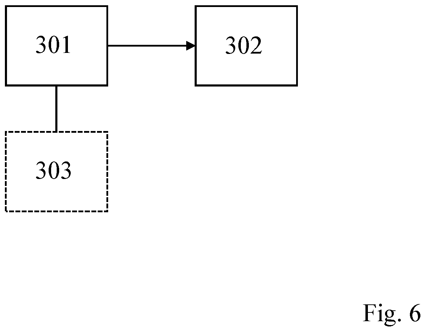

**Figure 6** summarizes some manufacturing steps in a flow diagram. The method may comprise forming 301 the isolation well and forming 302 the isolation trench. As discussed with reference to figures 4 and 5, the buried first doping type region may be formed 303 when the isolation well is formed 301.

## Claims

1. A semiconductor die (1) with a semiconductor body (10), the semiconductor die (1) comprising:
a vertical transistor device (20);
an additional transistor device (40) comprising a channel region (43.1) configured for a vertical current flow;
an isolation trench (60) extending into the semiconductor body (10);
an isolation well (70) made of a second doping type;
the isolation well (70) being arranged vertically below the additional transistor device (40),
the isolation trench (60) being arranged laterally between the additional transistor device (40) and the vertical transistor device (20),
wherein the isolation trench (60) extends to a depth (65) which lies vertically between an upper end (70.1) of the isolation well (70) and the second side (10.2) of the semiconductor body (10).

2. The semiconductor die (1) of claim 1,
the vertical transistor device (20) comprising:
a first vertical load region (21) arranged at a first side (10.1) of the semiconductor body and a second vertical load region (22) arranged at a second side (10.2) of the semiconductor body (10) opposite to the first side (10.1);
the first vertical load region (21) and the second vertical load region (22) made of a first doping type opposite to the second doping type.

3. The semiconductor die (1) of claim 1 or 2, wherein the isolation trench (60) extends through the isolation well (70), and wherein a lower end (60.2) of the isolation trench (60) is arranged on the same vertical height as or below a lower end (70.2) of the isolation well (70).

4. The semiconductor die (1) of any one of the preceding claims, at least one of the vertical transistor device (20) and the additional transistor device (40) comprising at least one gate trench (25, 45), wherein the isolation trench (60) extends deeper than the at least one gate trench (25, 45).

5. The semiconductor die (1) of any one of the preceding claims, the isolation trench (60) forming a closed line around the additional device (20), wherein the isolation well (70), as seen in a vertical cross-section, completely fills an area enclosed by the isolation trench (60).

6. The semiconductor die (1) of any one of the preceding claims, the semiconductor body (10) comprising a semiconductor substrate (11) and an epitaxial layer (12), wherein the isolation well (70) is formed in the epitaxial layer (12) in an area (140) of the additional transistor device (40) and a buried first doping type region (112) is formed in the epitaxial layer (12) in an area (120) of the vertical transistor device (20).

7. The semiconductor die (1) of any one of the preceding claims,
the additional transistor device (40) comprising:
a first additional load region (41) and a second additional load region (42);
the first additional load region (41) arranged at a first side (10.1) of the semiconductor body (10) and the second additional load region (42) embedded into the semiconductor body (10), namely arranged vertically between the first side (10.1) of the semiconductor body (10) and the isolation well (70).

8. The semiconductor die (1) of claim 7, wherein the second additional load region (42) is electrically connected to a terminal of the vertical transistor device (20), in particular to a gate electrode (35) of the vertical transistor device (20), via a contact element (80) which extends from the first side (10.1) into the semiconductor body (10).

9. The semiconductor die (1) of claim 8, wherein a surrounding trench (90), which extends to a depth (95) above the second additional load region (42), is arranged laterally between the additional transistor device (40) and the contact element (80).

10. The semiconductor die (1) of any one of claims 7 to 9, wherein an intermediate region (113), which is undoped or is made of the first doping type but with a lower doping concentration compared to the second additional load region (42), is arranged vertically between the second additional load region (42) and the isolation well (70).

11. The semiconductor die (1) of any one of claims 7 to 10, the semiconductor body (10) comprising a semiconductor substrate (11) and an epitaxial layer (13), wherein the second additional load region (42) of the additional transistor device (40) is formed in the epitaxial layer (13) in an area (140) of the additional transistor device (40) and an embedded first doping type region (122) is formed in the epitaxial layer (13) in an area (120) of the vertical transistor device (20).

12. A method of manufacturing the semiconductor die (1) of any one of the preceding claims, comprising:
- forming (302) the isolation trench (60);
- forming (301) the isolation well (70).

13. The method of claim 12 for manufacturing the semiconductor die (1) of claim 6, wherein forming the isolation well (70) and forming (303) the buried first doping type region (112) comprises:
i) Forming an epitaxial sublayer (12.1) of a second doping type;
ii) Locally introducing a first doping type implantation (201) to form at least a portion of the buried first doping type region (112)
wherein steps i) and ii) are in particular repeated a plurality of times.

14. The method of claim 12 for manufacturing the semiconductor die of claim 6, wherein forming the isolation well (70) and forming (303) the buried first doping type region (112) comprises:
i) Forming an epitaxial layer (12);
ii) Etching, in at least one of an area (120) of the vertical transistor device (20) and an area (140) of the additional transistor device (40), trenches (210) into the epitaxial layer (12);
iii) Introducing an implantation (201, 202) obliquely into the trenches (210);
iv) Filling the trenches (210) with epitaxial fillers (215);
v) Outdiffusing the implantation (201) into the epitaxial fillers (215).

15. The method of claim 14, the implantation in step iii) being a first doping type implantation, wherein, prior to step ii), the epitaxial layer (12) is provided with a second doping type implantation (202), no trenches being etched in step ii) in the area (140) of the additional transistor device (40).

16. The method of claim 14, wherein the trenches (210) are etched in the area (120) of the vertical transistor device (20) and in the area (140) of the additional transistor device (40), wherein, prior to a first doping type implantation (201) in the area (120) of the vertical transistor device (20), a second doping type implantation (202) is introduced to all trenches (210).
